# EUROPEAN PATENT SPECIFICATION

(11) **EP 1 542 359 B1**
(45) Date of publication and mention of the grant of the patent: **29.07.2009**
(21) Application number: 04028604.9
(22) Date of filing: 02.12.2004
(51) Int. Cl.: H03G 9/02

(54) **Signal compression/expansion device and mobile communication terminal**
Gerät zur Dynamikbegrenzung/-dehnung und mobiles Kommunikationsgerät
Appareil pour compression/expansion des signaux et dispositif mobile de communication

(30) Priority: 09.12.2003 JP 2003410212
(43) Date of publication of application: 15.06.2005
(73) Proprietor: NEC CORPORATION, Tokyo 108-8001, (JP)
(72) Inventor: Toki, Nozomi c/o NEC Corporation, Tokyo (JP)
(74) Representative: Glawe, Delfs, Moll

(56) References cited:
- WO-A-01/10020
- US-A- 4 467 287
- US-A- 4 882 762

## Description

### BACKGROUND OF THE INVENTION

### 1. Filed of the Invention

The present invention relates to a signal compression/expansion device, and more particularly to a signal compression/expansion device which controls an input signal with a gain in accordance with its level and a mobile communication terminal to which the signal compression/expansion device is applied.

### 2. Description of the Related Art

When voice signals and audio signals are amplified by an amplifier to be outputted to a speaker, a dynamic range is important. When a signal having large amplitude is inputted to the amplifier and the speaker, a waveform of the outputted signal is significantly distorted. When the sound with such distorted waveform is listened to, a listener feels it unpleasant. In order to solve such a problem, an automatic gain controller (AGC) has been generally used. In the automatic gain controller, when a signal reaches a predetermined level, a gain of an amplifier is decreased. As a result, an effective dynamic range of the amplifier is made wider. It should be noted that the "dynamic range" means a ratio of a level at which a signal/noise ratio (S/N ratio) has a predetermined value to a maximum level at which a signal saturates.

Particularly, a speaker built in a mobile communication terminal such as a cellular phone has an extremely smaller size than a speaker of a general an audio system, and its dynamic range and frequency characteristic are poor. Furthermore, a dynamic range of an amplifier for a speaker is narrow because of a limitation to a power supply. Accordingly, in a speaker built in a cellular phone, loud sound is distorted, and a low frequency area of the sound lacks sound pressure. Thus, a frequency characteristic has a peak in a high frequency range. Therefore, the automatic gain controller effectively widens a dynamic range. However, in a conventional automatic gain controller, an automatic gain control (that is, compression processing) has been performed for all ranges of a frequency band of an input signal, and a uniform dynamic range is formed.

Japanese Patent Laid-Open No. 2001-308730 discloses a digital receiver capable of widening a dynamic range of an A/D converter over a wide frequency band. In this receiver, a receiving signal over a wide band is divided by N band-pass filters. Furthermore, an automatic gain control amplifier amplifies the receiving signal so that the maximum signal level of an output of each band-pass filter becomes equal to 1/N of the maximum input level of the A/D converter, and adds the amplified receiving signals. As a result, signals having a very high level, which are included in the receiving signals, are suppressed, and signals having a very low level, which are included therein, are amplified. The digital receiver adjusts an amplification rate for each band of the input signal based on a signal level for each band, and forms a dynamic range. However, even if the foregoing technology is applied to a cellular phone showing poor dynamic range and frequency characteristic, it is difficult to obtain preferable sound from a speaker of the cellular phone.

US-A-4 882 762 discloses a signal compression/expansion device comprising a frequency band division circuit, a compression/expansion circuit and a frequency band synthesis circuit for adding signals outputted from the respective compression/expansion circuit, wherein at least one compression/expansion circuit applies a different gain for the input signal in accordance with a level of the input signal.

### Summary of the invention

The above-mentioned deficiencies of the prior art are overcome by the features of the main claim.

Advantages embodiments are mentioned in the sub claims.

### BRIEF DESCRIPTION OF THE DRAWINGS

The above and other objects, features and advantages of the present invention will become apparent from the following detailed description when taken with the accompanying drawings in which:
FIG. 1 is a block diagram of a signal compression/expansion device of an embodiment of the present invention;
FIG. 2 is a graph showing a frequency characteristic of a frequency band division circuit;
FIGS. 3A and 3B are block diagrams of an embodiment of a compression/expansion circuit;
FIGS. 4A, 4B, 4C and 4D are graphs showing examples of an I/O characteristic of the compression/expansion circuit;
FIG. 5 is a block diagram showing an embodiment of a mobile communication terminal; and
FIG. 6 is a block diagram of the signal compression/expansion device of another embodiment of the present invention.

### DETAILED DESCRIPTION OF THE PREFERRED EMBODIMENTS

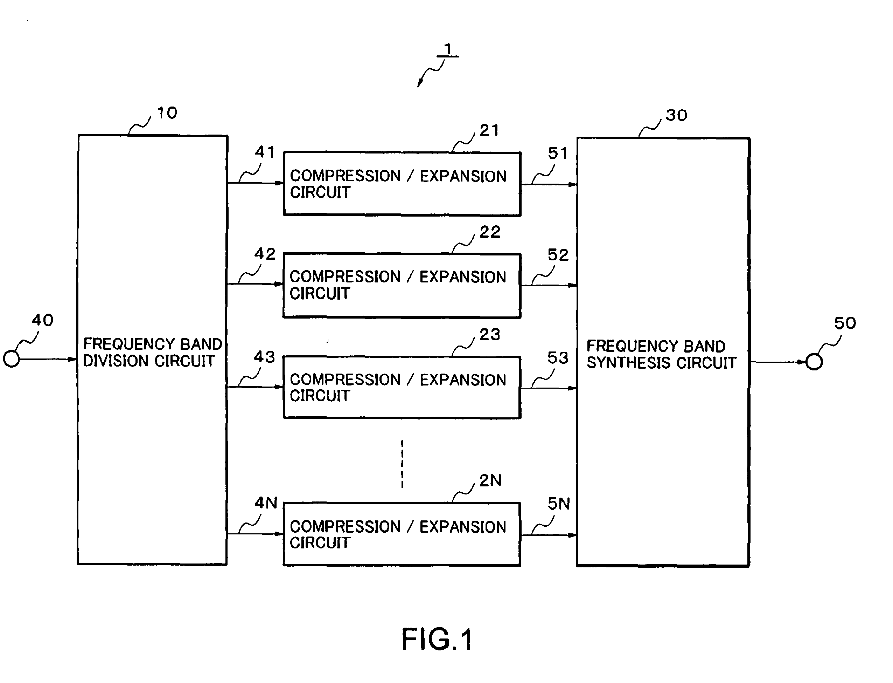

Preferred embodiments of a signal compression/expansion device of the present invention are described below. Referring to FIG. 1, a frequency band division circuit 10 receives a signal through an input terminal 40, and divides the signal into N frequency bands. Then, the frequency band division circuit 10 outputs signals 41, 42, 43,....., and 4N corresponding to the respective frequency bands. A compression/expansion circuits 21, 22, 23,...., and 2N respectively receive the signals 41, 42, 43,....., and 4N. The respective compression/expansion circuits adjust levels of the input signals in accordance with their levels, and output the signals. The compression/expansion circuits are capable of possessing intrinsic I/O characteristics respectively, and output the signals after compressing/expanding levels of the input signals based on the respective I/O characteristics. The compression can mean that the input signal is output in a state where its level is suppressed. The expansion can mean that the input signal is output in a state where its level is elevated. A frequency band synthesis circuit 30 adds the signals 51, 52, 53,....and 5N, which are outputted from the respective compression/expansion circuits 21, 22, 23,....., and 2N, and outputs an addition result to an output terminal 50. The output terminal 50 is connected to a speaker or an amplifier for driving the speaker, which are not illustrated in FIG. 1.

Herein, in at least one circuit among the compression/expansion circuits 21, 22, 23,....and 2N, a gain applied to an input signal smaller than a predetermined level (threshold value) differs from that applied to another input signal higher than the predetermined level. A compression/expansion circuit which compresses/expands the input signal with a constant gain can be also arranged. Note that a "level" does not mean an instantaneous value of a signal but means an effective value or a value equivalent to a short-time average such as a power or an envelope signal. The compression/expansion circuit variously compresses/expands levels of signals in respective frequency bands in accordance with a dynamic range of a speaker or an amplifier for driving the speaker. As a result, occurrence of distortion of an acoustic signal outputted from the speaker is suppressed.

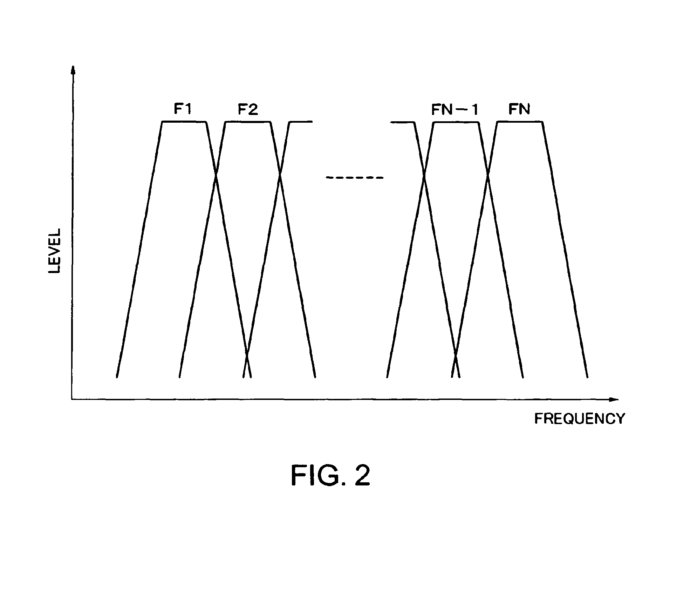

FIG. 2 is a graph illustrating an example of a frequency characteristic of the frequency band division circuit 10. The circuit 10 divides the input signal to N bands including the frequency bands F1, F2, ....., FN-1, and FN, and output the signals. The circuit 10 has N band pass filters, for example.

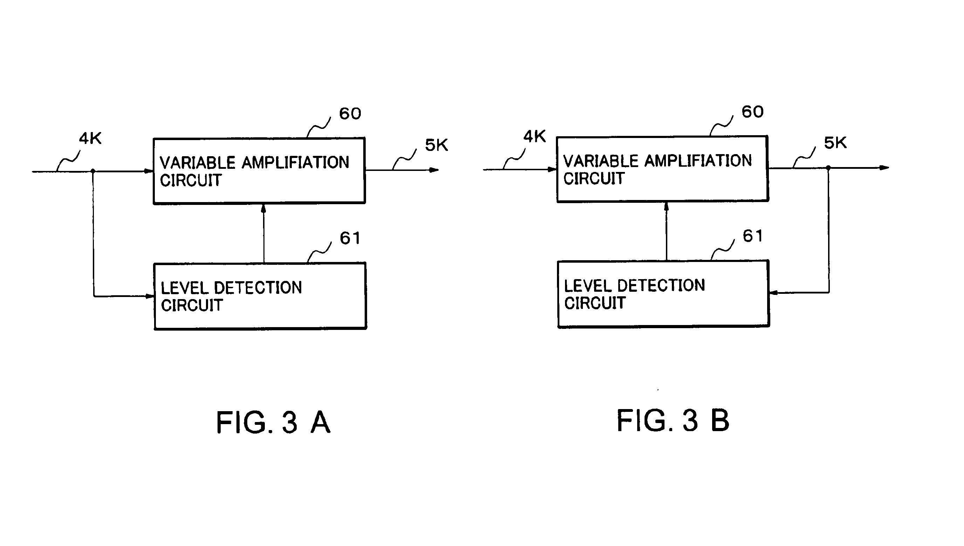

FIG.3A and FIG.3B show examples of the compression/expansion circuit. The compression/expansion circuit has a variable amplification circuit 60 and a level detection circuit 61. Referring to FIG. 3A, the compression/expansion circuit has a feed-forward type of configuration. A signal 4K is inputted to the variable amplification circuit 60 and the level detection circuit 61. The level detection circuit 61 monitors a signal level of the input signal 4K, and compares the signal level with a predetermined threshold value. Thereafter, the level detection circuit 61 outputs a comparison result to the variable amplification circuit 60. The variable amplification circuit 60 changes its amplification rate (that is, gain) in accordance with the signal received from the level detection circuit 61. An increase in the rate corresponds to an expansion of the input signal, and a decrease in the rate corresponds to a compression of the input signal. Alternatively, when the rate is smaller than one, the signal can be compressed. When the rate is larger than one, the signal can be expanded. The variable amplification circuit 60 outputs a signal 5K to the frequency synthesis circuit 30. Referring to Fig. 3B, the compression/expansion circuit has a feedback type of configuration. The input signal 4K is inputted to the variable amplification circuit 60. The level detection circuit 61 monitors a signal level of the signal 5K outputted from the variable amplification circuit 60, and outputs a monitor result to the variable amplification circuit 60. The variable amplification circuit 60 changes its amplification rate (that is, gain) in accordance with the monitor result which is outputted from the level detection circuit 61. The level detection circuit 61 is capable of comparing the level of the output signal of the variable amplification circuit 60 with a predetermined threshold value, and of outputting a comparison result to the variable amplification circuit. Alternatively, the level detection circuit 61 is capable of outputting the detected level of the output signal of the variable amplification circuit 60 to the variable amplification circuit 60.

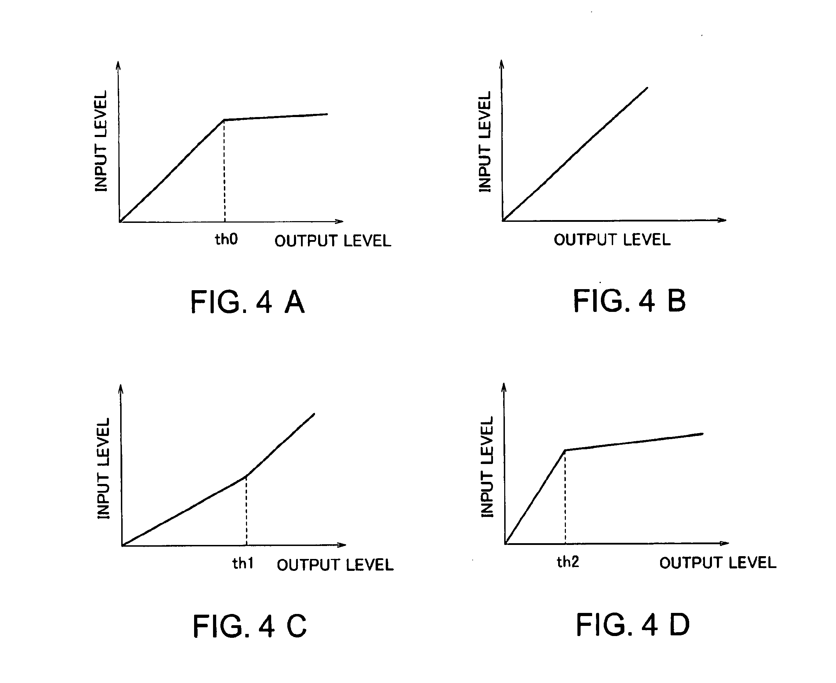

An example of an I/O characteristic of the compression/expansion circuit is shown below. In FIG. 4A, when a level of an input signal exceeds a threshold value th0, an amplification rate (i.e. gain) decreases. When the level of the input signal exceeds the threshold value th0, the level of the input signal can be compressed. In FIG. 4B, the amplification rate does not change, and a level of an output signal changes linearly with respect to the level of the input signal. There is a chance that the input signal may not be compressed/expanded. In FIG. 4C, when the level of the input signal exceeds the threshold value th1, the amplification rate increases. Alternatively, when the level of the input signal is equal to the threshold value th1 or less, there is a chance that the level of the output signal may be compressed. When the level of the input signal is equal to the threshold value th1 or more, there is a chance that the level of the output signal may not be compressed/expanded. In FIG. 4D, when the level of the input signal exceeds a threshold value th2, the amplification rate decreases. When the level of the input signal is equal to the threshold value th2 or less, there is a chance that the level of the input signal may be expanded. When the level of the input signal exceeds the threshold value th2, there is a chance that the level of the input signal may be compressed. The compression/expansion circuit can have a plurality of threshold values.

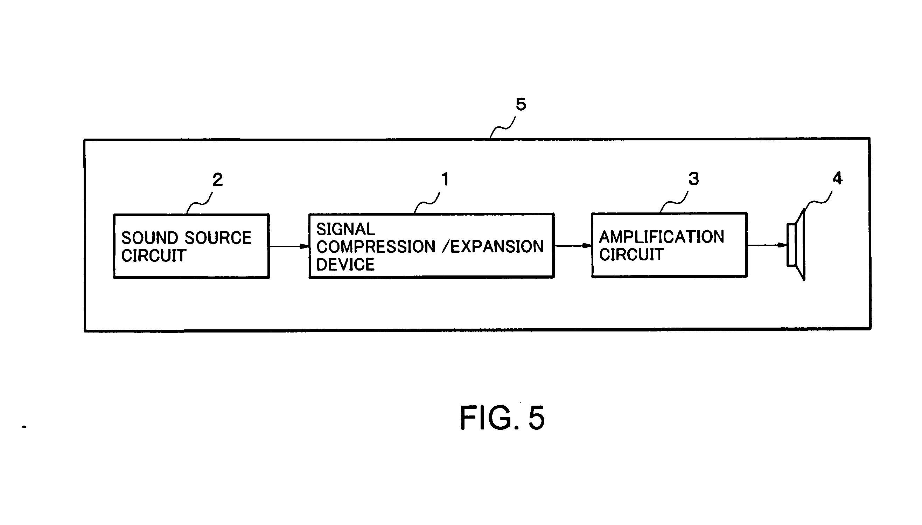

FIG. 5 shows an example of a mobile communication terminal loading the foregoing signal compression/expansion device. The mobile communication terminal 5 comprises a sound source circuit 2, a signal compression/expansion device 1, an amplification circuit 3 and a speaker 4. The sound source circuit 2 generates a sound source signal such as incoming call sound (e.g. incoming call melody). An output signal from the sound source circuit 2 is inputted to the signal compression/expansion device 1, and compressed/expanded depending on respective frequency bands. The amplification circuit 3 amplifies the signal compressed/expanded to drive the speaker 4. Note that if the level of the output signal of the signal compression/expansion device 1 is high enough to drive the speaker 4, the amplification circuit 3 needs not to be provided.

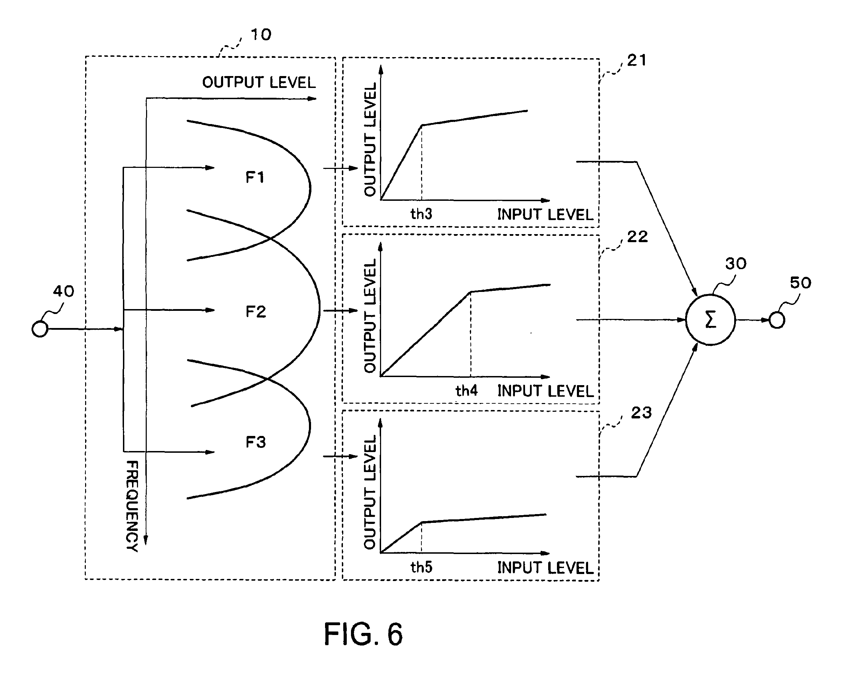

FIG. 6 shows another example of the signal compression/expansion device of the present invention. The frequency band division circuit 10 divides the input signal into three frequency bands. The compression/expansion circuit 21 corresponding to the low frequency band F1 has an I/O characteristic shown in FIG. 4D. This compression/expansion circuit 21 expands the input signal with a high amplification rate in order to compensate sound pressure of the speaker at a low frequency band. Another reason why this operation is performed is because it is difficult for a human to listen to a low frequency signal of a small sound volume. The compression/expansion circuit 22 corresponding to the intermediate frequency band F2 has an I/O characteristic shown in FIG. 4A. In this I/O characteristic, a threshold value th4 is set to a region of a large input level (that is, th4>th3). Since distortion occurs in a region where a level of the input signal is high, a compression characteristic is desirable. The compression/expansion circuit 23 corresponding to the high frequency band F3 has an I/O characteristic shown in FIG. 4A. However, since a high frequency band sometimes has a peak, a threshold value th5 is set to a region of a low input level. When the level of the input signal becomes high, sound in a high frequency is emphasized. To prevent this phenomenon, the compression characteristic is preferable. In addition, an amplification rate of the compression/expansion circuit can be set to a low value so that the output level equal to the threshold value th5 or less is made to be low.

The signal compression/expansion device can be configured as a device for processing an analog signal. Furthermore, the signal compression/expansion device can be realized by a digital signal processing device. For example, the frequency band division circuit 10 is realized by a Fourier transform circuit, and the band synthesis circuit 30 is realized by an inverse Fourier transform circuit. Thus, it is possible to execute operations of the compression/expansion circuits 21, 22, 23,....and 2N by the digital signal processing.

While the present invention has been described in connection with certain preferred embodiments, it is to be understood that the subject matter encompassed by the present invention is not limited to those specific embodiments. On the contrary, it is intended to include all alternatives, modifications, and equivalents as can be included within the scope of the following claims.

## Claims

1. A signal compression/expansion device for a mobile communication terminal, comprising:
a frequency band division circuit (10) for dividing an input signal into three frequency bands, namely a low frequency band (F1), an intermediate frequency band (F2) and a high frequency band (F3);
compression/expansion circuits (21 - 23) for receiving the input signal of a predetermined frequency band and for controlling a level of the input signal based on a predetermined gain; and
a frequency band synthesis circuit (30) for adding signals (51 - 53) outputted from the respective compression/expansion circuits (21-23),
***characterized* in that** the circuit (21) expands the low frequency bands signal (F1) with a high amplification rate when the level of the low frequency signal is lower than a first level (th3),
the circuit (22) compresses the intermediate frequency band signal (F2) when the level of the intermediate frequency band signal is higher than a second level (th4) which is higher than said first level (th3), and
the circuit (23) compresses the high frequency signal (F3) when the level of the high frequency band signal (F3) is higher than a third level (th5) which is lower than said second level (th4).

2. The signal compression/expansion device according to claims 1
wherein at least one compression/expansion circuit (21-2N) comprises a variable amplification circuit (60) and a level detection circuit (61),
the level detection circuit receives a signal outputted from the frequency band division circuit (10), and compares the received signal with a predetermined level, thus outputting a comparison result to the variable amplification circuit (60), and
the variable amplification circuit (60) receives the signal outputted from the frequency band division circuit (10), and controls the level of the signal with a predetermined gain in accordance with the comparison result, thus outputting the signal.

3. The signal compression/expansion device according to claim 1
wherein at least one compression/expansion circuit comprises a variable amplification circuit (60) and a level detection circuit (61),
the variable amplification circuit (60) receives a signal outputted from the frequency band division circuit (10), and controls the level of the received signal with a predetermined gain based on a signal received from the level detection circuit (61), thus outputting the signal, and
the level detection circuit (61) receives a signal outputted from the compression/expansion circuit (21 - 2N), and outputs a predetermined signal to the variable amplification circuit (60) according to the received signal level.

4. A mobile communication terminal, comprising:
a sound source circuit;
a signal compression/expansion device according to claim 1
for controlling a level of a signal outputted from the sound source signal based on a predetermined gain; and
a speaker for converting a signal outputted from the signal compression/expansion device to a sound.

## Patentansprüche

1. Vorrichtung zur Signalkompression/-expansion für ein mobiles Kommunikationsgerät, mit:
einer Frequenzbandteilungsschaltung (10) zum Teilen eines Eingangssignals in drei Frequenzbänder, nämlich ein Niederfrequenzband (F1), ein Zwischenfrequenzband (F2) und ein Hochfrequenzband (F3);
Kompressions-/Expansionsschaltungen (21, 23) zum Empfangen des Eingangssignals eines vorbestimmten Frequenzbandes und zum Steuern eines Pegels des Eingangssignals auf der Grundlage eines vorbestimmten Verstärkungsfaktors; und
einer Frequenzbandsyntheseschaltung (30) zum Addieren von Signalen (51-53), die von den entsprechenden Kompressions-/Expansionsschaltungen (21-23) ausgegeben worden sind,
**dadurch gekennzeichnet, dass** die Schaltung (21) das Niederfrequenzbandsignal (F1) mit einer hohen Verstärkungsrate expandiert, wenn der Pegel des Niederfrequenzsignals niedriger als ein erster Pegel (th3) ist,
die Schaltung (22) das Zwischenfrequenzband (F2) komprimiert, wenn der Pegel des Zwischenfrequenzbandsignals höher als ein zweiter Pegel (th4) ist, der höher als der erste Pegel (th3) ist, und
die Schaltung (23) das Hochfrequenzsignal (F3) komprimiert, wenn der Pegel des Hochfrequenzbandsignals (F3) höher als ein dritter Pegel (th5) ist, der niedriger als der zweite Pegel (th4) ist.

2. Vorrichtung zur Signalkompression/-expansion nach Anspruch 1,
wobei wenigstens eine Kompressions-/Expansionsschaltung (21-2N) eine variable Verstärkungsschaltung (60) und eine Pegeldetektionsschaltung (61) aufweist,
die Pegeldetektionsschaltung von der Frequenzbandteilungsschaltung (10) ausgegebene Signal empfängt und das empfangende Signal mit einem vorbestimmten Pegel vergleicht, somit ein Vergleichsergebnis an die variable Verstärkungsschaltung (60) ausgibt, und
die variable Verstärkungsschaltung (60) ein von der Frequenzbandteilungsschaltung (10) ausgegebenes Signal empfängt und den Pegel des Signals mit einem vorbestimmten Verstärkungsfaktor in Übereinstimmung mit dem Vergleichsergebnis steuert, somit das Signal ausgibt.

3. Vorrichtung zur Signalkompression/-expansion nach Anspruch 1,
wobei wenigstens eine Kompressions-/Expansionsschaltung eine variable Verstärkungsschaltung (60) und eine Pegeldetektionsschaltung (61) aufweist,
die variable Verstärkungsschaltung (60) ein von der Frequenzbandteilungsschaltung (10) ausgegebenes Signal empfängt und den Pegel des empfangenen Signals mit einem vorbestimmten Verstärkungsfaktor basierend auf einem von der Pegeldetektionsschaltung (61) empfangenen Signals steuert, somit das Signal ausgibt, und
die Pegeldetektionsschaltung (61) ein von der Kompressions-/Expansionsschaltung (21-2N) ausgegebenes Signal empfängt und ein vorbestimmtes Signal an die variable Verstärkungsschaltung (60) in Übereinstimmung mit dem empfangenen Signalpegel ausgibt.

4. Mobiles Kommunikationsgerät mit:
einer Schallquellenschaltung;
einer Signalkompressions-/-expansionsvorrichtung gemäß Anspruch 1
zum Steuern eines Pegels eines von dem Schallquellensignal ausgegebenen Signals basierend auf einem vorbestimmten Verstärkungsfaktor; und
einem Lautsprecher zum Umwandeln eines von der Signalkompressions-/ -expansionsvorrichtung ausgegebenen Signals in einen Schall.

## Revendications

1. Dispositif de compression - expansion de signaux pour un terminal de communication mobile, comprenant :
un circuit de division de bande de fréquence (10) pour diviser un signal d'entrée en trois bandes de fréquence, à savoir, une bande de fréquence faible (F1), une bande de fréquence intermédiaire (F2) et une bande de fréquence élevée (F3) ;
des circuits de compression - expansion (21 - 23) pour recevoir le signal d'entrée d'une bande de fréquence prédéterminée et pour commander un niveau du signal d'entrée sur la base d'un gain prédéterminé ; et
un circuit de synthèse de bande de fréquence (30) pour ajouter des signaux (51 - 53) générés en sortie à partir des circuits de compression - expansion (21 - 23) ;
***caractérisé* en ce que** le circuit (21) accroît le signal de bande de fréquence faible (F1) par le biais d'un taux d'amplification élevé lorsque le niveau du signal de fréquence faible est inférieur à un premier niveau (th3),
le circuit (22) comprime le signal de bande de fréquence intermédiaire (F2) lorsque le niveau du signal de bande de fréquence intermédiaire est supérieur à un deuxième niveau (th4), lequel est supérieur audit premier niveau (th3) ; et
le circuit (23) comprime le signal de fréquence élevée (F3) lorsque le niveau du signal de bande de fréquence élevée (F3) est supérieur à un troisième niveau (th5), lequel est inférieur audit deuxième niveau (th4).

2. Dispositif de compression - expansion de signaux selon la revendication 1,
dans lequel au moins un circuit de compression - expansion (21 - 2N) comprend un circuit d'amplification variable (60) et un circuit de détection de niveau (61) ;
le circuit de détection de niveau reçoit un signal généré en sortie à partir du circuit de division de bande de fréquence (10), et compare le signal reçu à un niveau prédéterminé, générant par conséquent en sortie un résultat de comparaison au niveau dudit circuit d'amplification variable (60) ; et
le circuit d'amplification variable (60) reçoit le signal généré en sortie en provenance du circuit de division de bande de fréquence (10), et commande le niveau du signal avec un gain prédéterminé selon le résultat de comparaison, générant par conséquent en sortie le signal.

3. Dispositif de compression - expansion de signaux selon la revendication 1,
dans lequel au moins un circuit de compression - expansion comprend un circuit d'amplification variable (60) et un circuit de détection de niveau (61) ;
le circuit d'amplification variable (60) reçoit un signal généré en sortie à partir du circuit de division de bande de fréquence (10), et commande le niveau du signal reçu avec un gain prédéterminé sur la base d'un signal reçu en provenance du circuit de détection de niveau (61), générant par conséquent en sortie le signal ; et
le circuit de détection de niveau (61) reçoit un signal généré en sortie à partir du circuit de compression - expansion (21 - 2N), et génère en sortie un signal prédéterminé au niveau du circuit d'amplification variable (60) selon le niveau de signal reçu.

4. Terminal de communication mobile, comprenant :
un circuit de source sonore ;
un dispositif de compression - expansion de signaux selon la revendication 1
pour commander un niveau d'un signal généré en sortie à partir d'un signal de source sonore sur la base d'un gain prédéterminé ; et
un haut-parleur pour convertir un signal généré en sortie à partir du dispositif de compression - expansion de signaux en un son.
